# EUROPEAN PATENT APPLICATION

(11) **EP 3 096 594 A1**
(43) Date of publication of application: **23.11.2016**
(21) Application number: 16152643.9
(22) Date of filing: 25.01.2016
(51) Int. Cl.: H05K 9/00

(54) **CIRCUIT PROTECTION STRUCTURE AND ELECTRONIC DEVICE**

(30) Priority: 21.05.2015 CN 201510263801
(71) Applicant: Xiaomi Inc., Beijing 100085 (CN)
(72) Inventor: YANG, Dawei, 100085 Beijing (CN); LI, Hui, 100085 Beijing (CN); ZHU, Dan, 100085 Beijing (CN); XU, Chunli, 100085 Beijing (CN)
(74) Representative: Sackin, Robert

(57) **Abstract**

A circuit protection structure is disclosed. The circuit protection structure comprises: a printed circuit board PCB (11), having thereon an electronic unit (111) and a grounded wireframe (12) surrounding the circuit unit (111); a conductive housing (14), having a receiving cavity to receive the circuit unit (111); and a conductive adhesive layer (13), provided between the grounded wireframe (12) and the conductive housing (14) for electrical connection between the grounded wireframe (12) and the conductive housing (14). In the present disclosure, the electronic unit (111) is protected by forming a Faraday cage structure by means of the combination of the conductive housing (14), the conductive adhesive layer (13), and the grounded wireframe (12) on the PCB (11), for the purpose of shielding the electromagnetic radiation so as to eliminate or reduce the electromagnetic radiation interference on the electronic unit (111), without increasing weight and size of the product caused by additional shielding conductive cover, and thus improving competitiveness of the product.

## Description

### TECHNICAL FIELD

The present disclosure generally relates to the technical field of communication circuits, and more particularly, to a circuit structure for shielding electromagnetic radiation, and an electronic device.

### BACKGROUND

Generally, "noise" in a circuit refers to the redundant signals causing purity distortion to the desired signal. The noise is spread in two ways: conduction and radiation. In the former way, the noise is spread from one place to another through a conductor, such as a wire, a printed circuit, a metallic housing of a device, a metallic frame of a device, or components in the circuit, etc.; while in the latter way, the noise is spread from one place to another through air or other dielectric media. Further, the conductive noise may be transformed into the radiation noise (i.e., the electromagnetic radiation) when meeting an adaptive antenna.

Several effective methods for reducing noise include shielding, filtering, grounding wire design and overall layout. Conductive noise is generally filtered out by means of traditional circuit technique, and radiative noise is minimized by means of shielding. The conductive noise may be dealt with by means of adding a filtering circuit as desired, because the position where the conductive noise exists in the system is commonly already known. However, the radiative noise is hard to be dealt with, for it is usually pervading within the whole system. In order to deal with the radiative noise, a shielding conductive cover may commonly be added to control the radiative noise of the system. However, adding such shielding conductive cover may increase the weight and size of the product, and increase additional costs of the product reducing its competitiveness.

### SUMMARY

For this, the present disclosure provides a circuit protection structure having a structure, and an electronic device, so as to solve the above-mentioned technical problems.

For this purpose, the present disclosure applies the following technical solutions:
According to a first aspect of embodiments of the present disclosure, there is provided a circuit protection structure, comprising:
   a printed circuit board PCB, having thereon a circuit unit and a grounded wireframe surrounding the circuit unit;
   a conductive housing, having a receiving cavity to receive the circuit unit; and
   a conductive adhesive layer, provided between the grounded wireframe and the conductive housing for electrical connection between the grounded wireframe and the conductive housing.

Optionally, the conductive adhesive layer may overlap with the grounded wireframe.

Optionally, the conductive adhesive layer may overlap with the outer edge of the conductive housing.

Optionally, the conductive adhesive layer may be a first conductive foam gasket; wherein opposite side surfaces of the first conductive foam gasket are adhered between the conductive housing and the grounded wireframe, respectively.

Optionally, the conductive adhesive layer may be a first conductive silicon gel, wherein opposite side surfaces of the first conductive silicon gel are adhered between the conductive housing and the grounded wireframe, respectively.

Optionally, the conductive adhesive layer may comprise a second conductive foam gasket and a second conductive silicon gel which are attached with each other, wherein the second conductive foam gasket is adhered to the conductive housing, and the second conductive silicon gel is adhered to the grounded wireframe.

Optionally, the conductive adhesive layer may comprise a third conductive foam gasket and a third conductive silicon gel which are attached with each other, wherein the third conductive foam gasket is adhered to the grounded wireframe, and the third conductive silicon gel is adhered to the conductive housing.

Optionally, the grounded wireframe may have a wire width of no more than 5 mm.

According to a second aspect of embodiments of the present disclosure, there is provided an electronic device, comprising a housing and at least one circuit protection structure installed within the housing, the circuit protection structure comprising:
a printed circuit board PCB, having thereon a circuit unit and a grounded wireframe surrounding the circuit unit;
a conductive housing, having a receiving cavity to receive the circuit unit; and
a conductive adhesive layer, provided between the grounded wireframe and the conductive housing for electrical connection between the grounded wireframe and the conductive housing.

Optionally, the conductive adhesive layer may overlap with the grounded wireframe.

Compared with the prior art, the circuit unit in the present disclosure is protected by forming a structure of a Faraday cage by means of the combination of the conductive housing, the conductive adhesive layer, and the grounded wireframe on the PCB, for the purpose of shielding electromagnetic radiation so as to eliminate or reduce the electromagnetic radiative interference on the circuit unit, without increasing weight and size of the product caused by additional shielding conductive cover, and thus improving competitiveness of the product.

### BRIEF DESCRIPTION OF THE DRAWINGS

Fig. 1 is an illustrative view showing the structure of the circuit protection structure according to the present disclosure;
Fig. 2 is an illustrative view showing the structure of the circuit protection structure according to the present disclosure and illustrated in Fig. 1 at another angle;
Fig. 3 is an illustrative exploded view showing the structure of the circuit protection structure according to an embodiment of the present disclosure;
Fig. 4 is an illustrative exploded view showing the structure of the circuit protection structure according to another embodiment of the present disclosure;
Fig. 5 is an illustrative exploded view showing the structure of the circuit protection structure according to another embodiment of the present disclosure; and
Fig. 6 is an illustrative exploded view showing the structure of the circuit protection structure according to another embodiment of the present disclosure.

### DETAILED DESCRIPTION

Detailed description will be made to the present disclosure with reference to the specific implementations illustrated by the accompanying drawings. However, the present disclosure is not intended to be limited to the implementations. The protection scope of the present disclosure covers any modifications made by those skilled in the art concerning structure, methods or functions to these implementations.

The terms in the present disclosure are used merely for the purpose of description of the particular embodiments, rather than intends to limit the present disclosure. Unless otherwise shown clearly in the context, the singular words "a", "said" and "the" used in the present disclosure and the appended claims are also intended to include the plural. It shall also be appreciated that the term "and/or" used herein refers to and includes any or all possible combinations of one or more relevant listed items.

It shall be appreciated, although various information in the present disclosure may be described by the terms "first", "second" and so on, this information is not limited by the terms. These terms are used merely for distinguishing information of the same type from each other. For example, the first information may also be referred as the second information without departing from the scope of the present disclosure. Similarly, the second information may also be referred as the first information. The word "if" used herein may be explained as "when..." or "while" or "response on confirmation", depending on the context.

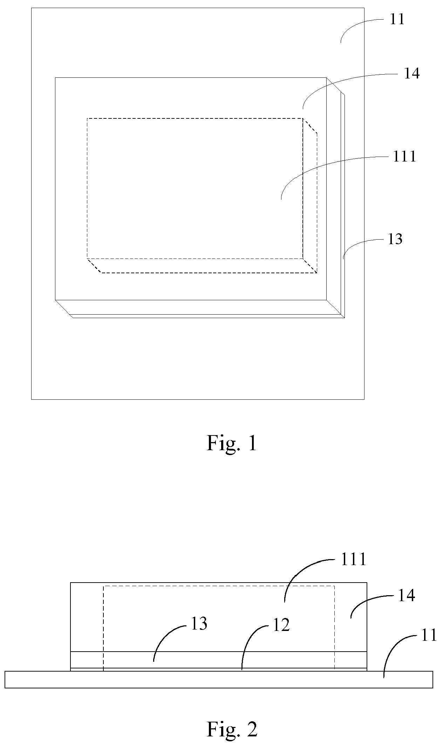

Fig. 1 is an illustrative view showing the partial structure of the circuit protection structure according to the present disclosure; and Fig. 2 is an illustrative view showing the entire structure of the circuit protection structure according to the present disclosure at another angle. The circuit protection structure of the present disclosure provides an enclosing encapsulation for the circuit unit 111 or electronic unit on the PCB (Printed Circuit Board) 11 by means of the principle of the Faraday cage, so as to shield the outside environment electromagnetic radiation, preventing the electromagnetic radiation from interfering with the circuit unit 111. Wherein the circuit unit 111 or electronic unit may be a CPU unit, an audio circuit unit, a video circuit unit, and so on.

In particular, the circuit protection structure of the present disclosure comprises: a PCB 11, a grounded wireframe 12, a conductive housing 14 and a conductive adhesive layer 13. Wherein the PCB 11 has thereon a circuit unit 111 or electronic unit and a grounded wireframe 12 surrounding the circuit unit 111. The grounded wireframe 12 is formed on the PCB 11 and forms a part of the printed circuit on the PCB 11. The grounded wireframe 12 may either be connected with the main grounding line on the PCB 11, or connected directly with the earth. In an embodiment of the present disclosure, the grounded wireframe 12 has a wire width of no more than 5 mm, and preferably, the grounded wireframe 12 has a width of about 2mm.

Furthermore, the grounded wireframe 12 is an enclosing structure located on the periphery of the circuit unit 111. In addition, the conductive housing 14 has a receiving cavity for receiving the circuit unit 111. The receiving cavity has a depth (i.e. the size of the conductive housing 14 in the direction of assembling to the circuit unit 111) no less than the height of the highest component in the circuit unit 111. Preferably, in order that the electronic device comprising the circuit protection structure can have a thinner dimension, the receiving cavity may have a depth equal to or slightly more than the height of the highest component in the circuit unit 111.

Furthermore, the conductive housing 14 of the present disclosure is sealed on the grounded wireframe 12 by a conductive adhesive layer 13. Of course, the conductive housing 14 may be further secured later by a bolt or etc. The conductive adhesive layer 13 is provided between the grounded wireframe 12 and the conductive housing 14 for electrical connection between the grounded wireframe 12 and the conductive housing 14, such that protection circuit structure may form a Faraday cage structure, keeping the circuit unit 111 from electromagnetic radiation. Optionally, the conductive adhesive layer 13 and the grounded wireframe 12 of the present disclosure may overlap with each other. Furthermore, the conductive adhesive layer 13 may overlap with the outer edges of the conductive housing 14. The portion of a side surface of the conductive housing 14 that contacts with the conductive adhesive layer 13 has the same shape and size as that of the grounded wireframe 12. This arrangement results in an optimal line transmission for the conductive adhesive layer 13 and the grounded wireframe 14, preventing disordered line connection caused by over-wide conductive adhesive layer 13 coming into connection with other lines on the PCB 11, or influenced electrical signal transmission caused by over-narrow conductive adhesive layer 13.

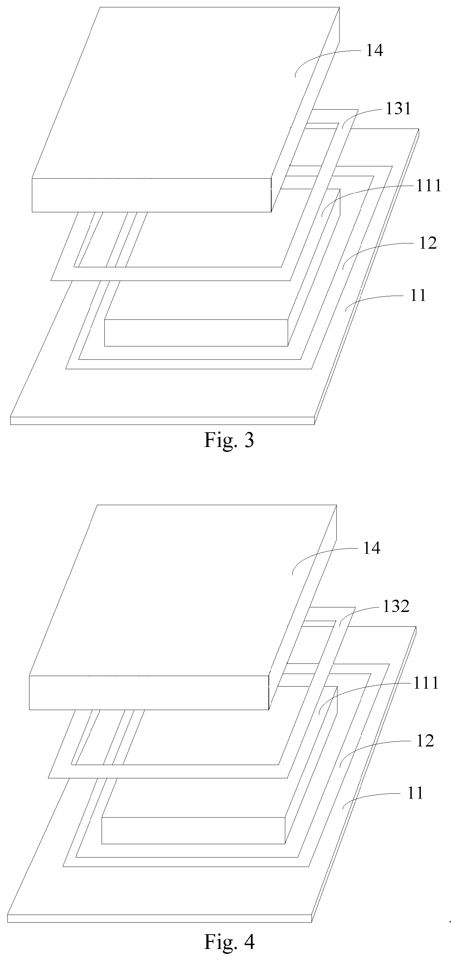

As shown in Figs. 1-3, the conductive adhesive layer 13 is a first conductive foam gasket 131. The opposite sides of the first conductive foam gasket 131 are adhered between the conductive housing 14 and the grounded wireframe 12. The opposite sides of the first conductive foam gasket 131 both include a conductive double-sided adhesive, such that the first conductive foam gasket 131 may bond the conductive housing 14 and the grounded wireframe 12 together and achieve electrical connection. In this embodiment, the closed structure of the Faraday cage is formed by one side of the first conductive foam gasket 131 being bonded to the grounded wireframe 12, and the other side of the first conductive foam gasket 131 being bonded to the conductive housing 14. What is more, by using the conductive foam gasket having the properties of good conduction and elasticity, the minor gaps between the conductive housing 14 and the PCB 11 may be filled effectively, such that the conductive housing 14 and the PCB 11 may contact completely with each other, so as to solve the problem that the shielding may be weak due to incomplete contact between the conductive housing 14 and the PCB 11. The incomplete contact may be caused by deformation of the PCB 11 during installation of the PCB 11.

As shown in Figs. 1, 2 and 4, the conductive adhesive layer 13 is a first conductive silicon gel 132. The opposite sides of the first conductive silicon gel 132 are adhered between the conductive housing 14 and the grounded wireframe 12, such that the conductive housing 14 and the grounded wireframe 12 may be bonded together and achieve electrical connection by the first conductive silicon gel 132. In this embodiment, the closed structure of Faraday's cage is formed by the first conductive silicon gel 132 being bonded respectively to the conductive housing 14 and the grounded wireframe 12, such that the conductive housing 14 and the PCB 11 may contact completely with each other, so as to solve the problem that the shielding may be weak due to incomplete contact between the conductive housing 14 and the PCB 11. The incomplete contact may be caused by deformation of the PCB 11 during installation of the PCB 11.

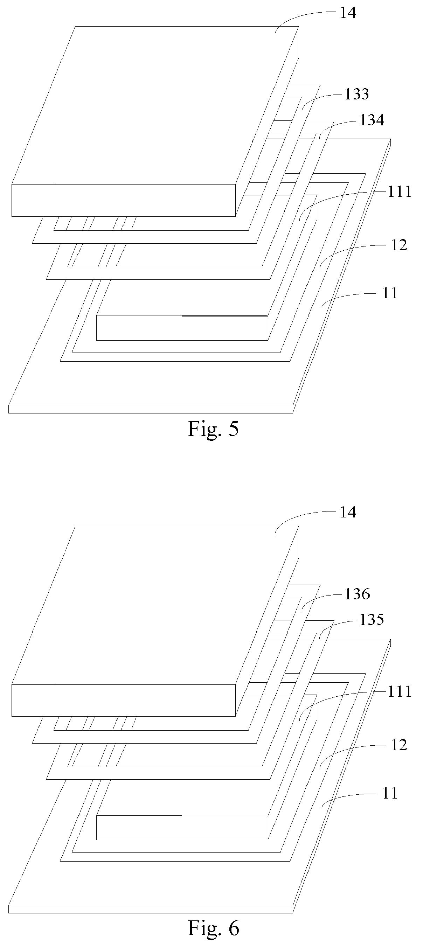

As shown in Figs. 1, 2 and 5, the conductive adhesive layer 13 comprises a second conductive foam gasket 133 and a second conductive silicon gel 134 that are attached to each other. The second conductive foam gasket 133 is adhered to the conductive housing 14, and the second conductive silicon gel 134 is adhered to the grounded wireframe 12. In this embodiment, the closed structure of a Faraday cage is formed by one side of the second conductive foam gasket 133 being bonded to the second conductive silicon gel 134, the other side of the second conductive foam gasket 133 being bonded to the conductive housing 14, and the other side, which is spaced from the side bonded to the second conductive foam gasket 133, of the second conductive silicon gel 134 being bonded to the grounded wireframe 12. Also, by using the conductive foam gasket having the properties of good conduction and elasticity, the minor gaps between the conductive housing 14 and the PCB 11 may be filled effectively, such that the conductive housing 14 and the PCB 11 may contact completely with each other, so as to solve the problem that the shielding may be weak due to the incomplete contact between the conductive housing 14 and the PCB 11, which incomplete contact may be caused by deformation of the PCB 11 during installation of the PCB 11.

As shown in Figs. 1, 2 and 6, the conductive adhesive layer 13 comprises a third conductive foam gasket 135 and a third conductive silicon gel 136 that are attached to each other. The third conductive foam gasket 135 is adhered to grounded wireframe 12, and the third conductive silicon gel 136 is adhered to conductive housing 14. In this embodiment, the closed structure of a Faraday cage is formed by one side of third conductive foam gasket 135 being bonded to the third conductive silicon gel 136, the other side of the third conductive foam gasket 135 being bonded to the grounded wireframe 12, and the other side, which is departed from the side bonded to the third conductive foam gasket 135, of the third conductive silicon gel 136 being bonded to the conductive housing 14. Also, by using the conductive foam gasket having the properties of good conduction and elasticity, the minor gaps between the conductive housing 14 and the PCB 11 may be filled effectively, such that the conductive housing 14 and the PCB 11 may contact completely with each other, so as to solve the problem that the shielding may be weak due to incomplete contact between the conductive housing 14 and the PCB 11. The incomplete contact may be caused by deformation of the PCB 11 during installation of the PCB 11.

An electronic device may be provided comprising a housing and at least one circuit protection structure installed within the housing, the circuit protection structure being the circuit protection structure according to any of the above-mentioned embodiments. In particular, the circuit protection structure comprises: a printed circuit board PCB 11, a grounded wireframe 12, a conductive housing 14, and a conductive adhesive layer 13 provided between the grounded wireframe 12 and the conductive housing 14 for electrical connection between the grounded wireframe 12 and the conductive housing 14. Wherein the PCB 11 has thereon a circuit unit 111or electronic unit and a grounded wireframe 12 surrounding the circuit unit 111. Preferably, the conductive adhesive layer 13 contacts the surface of the grounded wireframe 12 projecting on the PCB 11.Preferably, the conductive adhesive layer overlaps with the grounded wireframe. In this embodiment, the conductive adhesive layer 13 uses the same material and structure as that used in the conductive adhesive layer 13 of the above-mentioned circuit protection unit 111, which will not be repeated here.

The circuit unit or electronic unit in the present disclosure is protected by forming a structure of a Faraday cage by means of the combination of the conductive housing, the conductive adhesive layer, and the grounded wireframe, for the purpose of shielding electromagnetic radiation so as to eliminate or reduce the electromagnetic radiation interference on the circuit unit or electronic unit, without increasing weight and size of the product caused by an additional shielding conductive cover, and thus improving competitiveness of the product.

## Claims

1. A circuit protection structure comprising:
a printed circuit board, PCB (11), having thereon an electronic unit (111) and a grounded wireframe (12) surrounding the electronic unit (111);
a conductive housing (14) having a receiving cavity to receive the electronic unit (111); and
a conductive adhesive layer (13) provided between the grounded wireframe (12) and the conductive housing (14) for an electrical connection between the grounded wireframe (12) and the conductive housing (14).

2. The circuit protection structure of claim 1, wherein the conductive adhesive layer (13) overlaps with the grounded wireframe (12).

3. The circuit protection structure of claim 1 or 2, wherein the conductive adhesive layer (13) overlaps with an outer edge of the conductive housing (14).

4. The circuit protection structure of claim 3, wherein the conductive adhesive layer (13) is a first conductive foam gasket (131), wherein opposite sides of the first conductive foam gasket (131) are respectfully adhered between the conductive housing (14) and the grounded wireframe (12).

5. The circuit protection structure of claim 3, wherein the conductive adhesive layer (13) is a first conductive silicon gel (132), wherein opposite sides of the first conductive silicon gel (132) are respectively adhered between the conductive housing (14) and the grounded wireframe (12).

6. The circuit protection structure of claim 3, wherein the conductive adhesive layer (13) comprises a second conductive foam gasket (133) and a second conductive silicon gel (134) that are attached to each other, wherein the second conductive foam gasket (133) is adhered to the conductive housing (14), and the second conductive silicon gel (134) is adhered to the grounded wireframe (12).

7. The circuit protection structure of claim 3, wherein the conductive adhesive layer (13) comprises a third conductive foam gasket (135) and a third conductive silicon gel (136) that are attached to each other, and wherein the third conductive foam gasket (135) is adhered to the grounded wireframe (12), and the third conductive silicon gel (136) is adhered to the conductive housing (14).

8. The circuit protection structure of claim 1, **characterized in that**, the grounded wireframe (12) has a wire width of no more than 5 mm.

9. An electronic device, comprising a housing and at least one circuit protection structure installed within the housing, the circuit protection structure comprising:
a printed circuit board, PCB (11) having thereon an electronic unit (111) and a grounded wireframe (12) surrounding the electronic unit (111);
a conductive housing (14) having a receiving cavity to receive the electronic unit (111); and
a conductive adhesive layer (13) provided between the grounded wireframe (12) and the conductive housing (14) for an electrical connection between the grounded wireframe (12) and the conductive housing (14).

10. The electronic device of claim 9, wherein the conductive adhesive layer (13) overlaps with the grounded wireframe (12).
